# EUROPÄISCHE PATENTSCHRIFT

(11) **EP 2 732 209 B1**
(45) Veröffentlichungstag und Bekanntmachung des Hinweises auf die Patenterteilung: **09.09.2015**
(21) Anmeldenummer: 12753382.6
(22) Anmeldetag: 09.07.2012
(51) Int. Cl.: F21V 19/00, H01L 27/32, H01L 51/50, H01R 33/20, F21Y 105/00

(54) **LEUCHTMITTEL MIT WENIGSTENS EINER ORGANISCHEN, LICHT EMITTIERENDEN DIODE**
LUMINOUS MEANS COMPRISING AT LEAST ONE ORGANIC LIGHT-EMITTING DIODE
MOYEN D'ÉCLAIRAGE COMPORTANT AU MOINS UNE DIODE ÉLECTROLUMINESCENTE ORGANIQUE

(30) Priorität: 12.07.2011 DE 102011107642
(43) Veröffentlichungstag der Anmeldung: 21.05.2014
(73) Patentinhaber: BJB GmbH & Co. KG, 59755 Arnsberg (DE)
(72) Erfinder: VOGT, Karl-Wilhelm, 59469 Ense (DE); LUDWIG, Marco, 58739 Wickede (DE)
(74) Vertreter: Ostriga Sonnet Wirths & Vorwerk
(86) Internationale Anmeldenummer: PCT/DE2012/000684
(87) Internationale Veröffentlichungsnummer: WO 2013/007234

(56) Entgegenhaltungen:
- DE-A1- 2 346 745
- DE-A1-102006 015 437
- DE-A1-102006 054 584
- DE-T2- 60 306 721
- JP-A- 2006 331 856
- US-A1- 2006 012 985
- US-A1- 2006 285 361

## Beschreibung

Die Erfindung betrifft ein Leuchtmittel mit wenigstens einer organischen, Licht emittierenden Diode (OLED), die auf einem Trägermaterial aufgebracht sind, welches mit einer metallischen Schicht bedampft ist, die der Spannungsversorgung der OLED dient und hierfür mit Anschlussleitern in Verbindung steht. Ein Leuchtmittel nach dem Oberbegriff des Anspruchs 1 wird im Dokument JP-A-2006331856 offenbart.

Neben der Anwendung von anorganischen LEDs zum Ersatz herkömmlicher Leuchtmittel finden auch vermehrt LEDs Einsatz, die auf organischer Halbleitertechnik beruhen. Leuchtmittel mit organischen, Licht emittierenden Dioden (OLED) umfassen zumeist ein plattenförmiges Trägermaterial, insbesondere Glas, auf welchem die organischen Halbleiterbauteile aufgesetzt sind. Die Spannungs- und Stromversorgung übernimmt eine auf das Trägermaterial aufgedampfte Metallschicht. Rückseitig ist das Trägermaterial mit einer Abdeckung, zumeist einer weiteren Glasplatte, versehen. Die organischen Halbleiterbauteile sind so zwischen Trägermaterial und Abdeckung gelagert. Die Abdeckung lässt jedoch in Randbereichen den Zugang zur metallischen Schicht frei, so dass diese auf verschiedene Arten elektrisch kontaktiert werden kann.

So ist es beispielsweise bekannt, elektrische Leiter mit einem speziellem, leitfähigen Kleber auf der metallischen Schicht zu fixieren, um Elektrizität einspeisen zu können. Es besteht auch die Möglichkeit, mit einem leitfähigen Elastomer eine Verbindung herzustellen. Schließlich existiert ein Verfahren, um flexible Leiterplatten an der metallischen Schicht des Trägermaterials zu befestigen.

Die vorgenannten Möglichkeiten zur elektrischen Anbindung von Leuchtmitteln mit organischen LEDs haben ihre spezifischen Nachteile. So sind Klebeverbindungen gegenüber scherenden Beanspruchungen ausgesprochen empfindlich, weshalb solchermaßen elektrisch angebundene Leuchtmittel gewöhnlich innerhalb von Gehäusen mit separaten Anschlusskontakten angeordnet sind.

Bei der Nutzung von elektrisch leitenden Elastomeren ist es erforderlich, eine Kompression der Elastomere herbeizuführen, weshalb auch hier das Leuchtmittel gegen ein Widerlager gepresst werden muss. Zudem sind die Übergangswiderstände vom Elastomer zum Leuchtmittel vergleichsweise hoch.

Die Nutzung von flexiblen Leiterplatten zur elektrischen Anbindung organischer LEDs ist aufgrund der Empfindlichkeit der elektrischen Leiterplatten auch nur in bestimmten Anwendungsfällen sinnvoll.

Der vorgenannte Stand der Technik ist beispielsweise in Herstellerrichtlinien zur Kontaktierung von OLEDs beschrieben.

Eine Möglichkeit, OLEDs beinhaltende Leuchtmittel zu haltern, ist beispielsweise in DE 20 2006 012 937 U1 dargestellt und aus WO 2008/074431 A1 bekannt.

Zusammenfassend besteht im Stand der Technik ein dringender Bedarf, die elektrische Kontaktierung von OLEDs beinhaltenden Leuchtmitteln wie auch deren Halterung zu verbessern.

Aufgabe der Erfindung ist es, eine vorteilhafte elektrische Anbindung und Halterung von Leuchtmitteln auf Basis von OLEDs bereitzustellen.

Gelöst wird die Aufgabe von einem Leuchtmittel mit den Merkmalen des Anspruchs 1, welches sich dadurch kennzeichnet, dass wenigstens ein Anschlusskontakt einerseits stoffschlüssig an zumindest der metallischen Schicht angebunden ist und andererseits unmittelbar in einem Isolierstoffgehäuse festgelegt ist.

Der wesentliche Vorteil der Erfindung ist darin zu sehen, dass der Anschlusskontakt nicht nur der Spannungsversorgung des Leuchtmittels, sondern auch zu dessen Halterung an einem anderen Bauteil dient. Dabei ist der Kontakt unmittelbar im Isolierstoff festgelegt, welcher seinerseits beispielsweise ein Bauteil einer Leuchte darstellen kann, bevorzugt jedoch als eine Art Sockel des Leuchtmittels dient. Die bislang getrennt voneinander betrachteten und gelösten Aufgaben der elektrischen Kontaktierung und der mechanischen Halterung des Leuchtmittels werden hier in einem Bauteil vereint.

Zur Herstellung der stoffschlüssigen Verbindung zwischen metallischer Schicht des Trägermaterials und Anschlusskontakt ist insbesondere das Ultraschall-Löten vorgesehen. Ein Schweißen oder Kleben ist jedoch ebenfalls möglich.

Üblicherweise werden OLED-Leuchtmittel mit mehreren Anschlusskontakten pro Pol versehen, um eine gleichmäßige Spannungs- und Stromversorgung über die mit OLEDs versehene Trägerfläche sicherzustellen. Üblicherweise sind pro Pol mehrere Kontakte vorgesehen. Wenn gemäß einer bevorzugten Ausführungsform das Isolierstoffgehäuse das Leuchtmittel einbettet und so einen Sockel für das Leuchtmittel im klassischen Sinne bildet, können in einer weiteren bevorzugten Ausführungsform gleichartige Pole innerhalb des Isolierstoffgehäuses miteinander elektrisch verbunden werden. Dies hat den wesentlichen Vorteil, dass lediglich zwei der Anschlusskontakte der externen elektrischen Anbindung dienen und der ansonsten notwendige Verdrahtungsaufwand erheblich reduziert ist.

Es ist denkbar und vorteilhaft, wenn die mit der metallischen Schicht in Verbindung stehenden Kontakte mittelbar, aber insbesondere unmittelbar von außen zugänglich im Isolierstoffgehäuse gelagert sind. So kann an den Anschlusskontakten Elektrizität zur Versorgung eines weiteren Leuchtmittels abgenommen werden.

Die Funktion des Anschlusskontaktes als mechanisches Halteelement für das Leuchtmittel in einem Isolierstoff ermöglicht es, ein Isolierstoffgehäuse bzw. einen Sockel für das Leuchtmittel zu schaffen, der mit der Oberflächenebene der Sichtfläche des Leuchtmittels abschließt und dieses nicht überdeckt. So sind durch Aneinanderreihen mehrerer gleichartiger Leuchtmittel einheitliche Flächenleuchten herstellbar.

Weitere Vorteile der Erfindung folgen aus der nachfolgenden Beschreibung eines Ausführungsbeispiels. Es zeigen:
- Fig. 1:: ein erfindungsgemäßes Leuchtmittel in Explosionsdarstellung,
- Fig. 2: das zusammengesetzte Leuchtmittel gemäß Fig. 1 in vertikaler Schnittdarstellung,
- Fig. 3:: Eine Teilansicht des Leuchtmittels gemäß Fig. 2 mit Blick auf einen Anschlusskontakt.

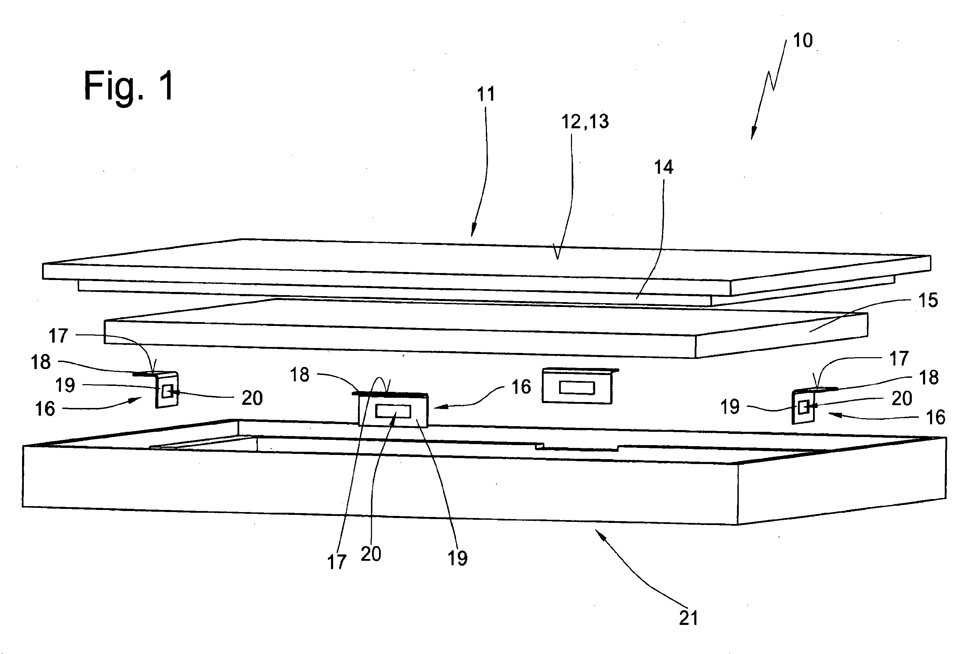

In den Figuren ist ein Leuchtmittel gemäß der Erfindung insgesamt mit der Bezugsziffer 10 versehen. Das Leuchtmittel 10 umfasst zunächst eine Trägerplatte 11 aus Glas, deren von einem Betrachter wahrzunehmenden Sichtfläche 12, die die Licht emittierende Oberfläche 13 bildet, hinsichtlich der Fig. 1 nach oben gewandt ist.

Auf der Unterseite der Trägerplatte 11 ist zunächst eine hier nicht näher dargestellte metallische Schicht aufgedampft, die im Randbereich der Trägerplatte 11 frei zugänglich ist und der Anbindung von elektrischen Anschlüssen dient. In einem durch eine Abdeckplatte 14 überdeckten Bereich bildet die metallische Schicht Leiterbahnen zur Spannungsversorgung von auf der Trägerplatte 11 aufgebrachten, organischen, Licht emittierenden Dioden (OLED) aus. Die Abdeckplatte 14 ist auf der der Sichtfläche abgewandten Seite der Trägerplatte 11 angeordnet, so dass insbesondere die OLEDs zwischen Trägerplatte 11 und Abdeckplatte 14 liegen.

Unterhalb der Abdeckplatte 14 ist in Fig. 1 ein Kühlkörper 15 dargestellt, der in seinen Abmessungen in etwa der Abdeckplatte 14 entspricht und in zusammengesetztem Zustand des Leuchtmittels 10 unmittelbar an der Abdeckplatte 14 angesetzt ist. Der Kühlkörper 15 dient der Abfuhr der beim Betrieb der OLEDs entstehenden Wärme.

Dargestellt sind weiterhin elektrische Anschlusskontakte 16. Diese weisen eine zur Trägerplatte 11 gerichtete Kontaktfläche 17 auf, mit welcher sie an der im Randbereich der Trägerplatte 11 zugänglichen, metallischen Schicht angeordnet werden. Die Kontaktfläche 17 wird durch einen ersten Kontaktschenkel 18 des Anschlusskontaktes 16 gebildet. Ein zweiter Kontaktschenkel 19 des Anschlusskontaktes 16 ist in Fig. 1 rechtwinklig zum ersten Kontaktschenkel 18 angeordnet und mit einer Halteöffnung 20 versehen. Schließlich ist in Fig. 1 ein rahmenartiges Isolierstoffgehäuse 21 dargestellt, welches die vorbeschriebenen Bauteile aufnimmt.

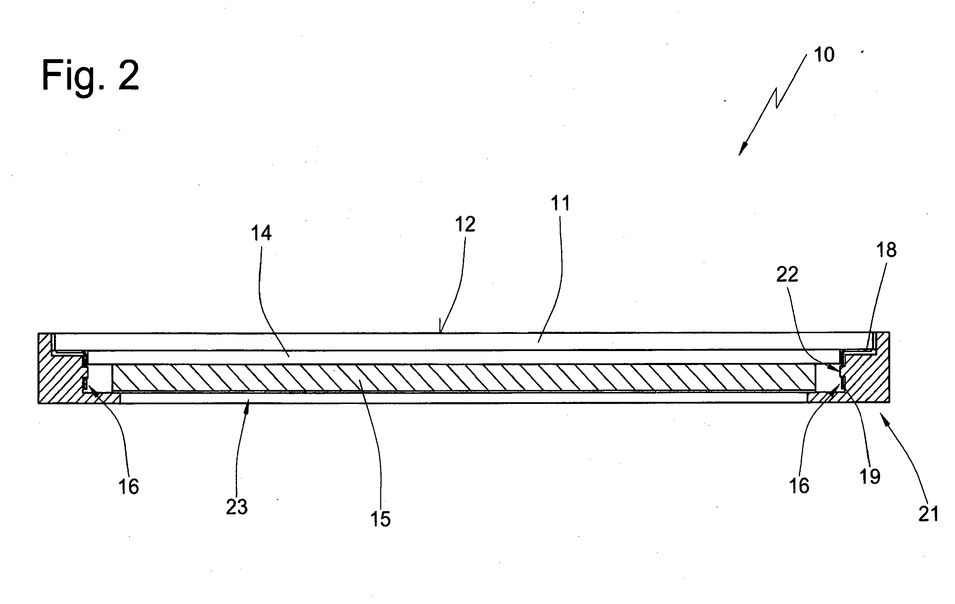

In Fig. 2 ist ein Vertikalschnitt durch das Leuchtmittel 10 der Fig. 1 gezeigt. Das Leuchtmittel 10 ist in Fig. 2 zusammengesetzt. Wie aus Fig. 2 ersichtlich ist, schließt das Isolierstoffgehäuse 21 mit der Ebene der Sichtfläche 1 ab. Keine Teile des Isolierstoffgehäuses 21 bedecken die Sichtfläche 12.

Die Anschlusskontakte 16 sind stoffschlüssig mit der auf die Trägerplatte 11 unterseitig aufgedampften metallischen Schicht über die Kontaktfläche 17 des ersten Kontaktschenkels 18 verbunden. Die Halteöffnung 20 des zweiten Kontaktschenkels 19 ist von einem Haltezapfen 12 durchgriffen, der vom Isolierstoffgehäuse 21 ausgebildet ist. Der Kühlkörper 15 ist an der Abdeckplatte 14 angeordnet. Zur Optimierung des Wärmeüberganges von der Abdeckplatte 14 auf den Kühlkörper 15 kann im Bereich der aneinandergrenzenden Oberflächen eine Wärmeleitpaste oder -folie vorgesehen sein. Der dem Kühlkörper 15 naheliegende Bodenbereich des Isolierstoffgehäuses 21 ist mit einer Ausnehmung 23 versehen. Über diese ist es möglich, einen weiteren, leuchtenseitigen Kühlkörper mit dem Kühlkörper 15 des Leuchtmittels 10 zu kontaktieren, um die Wärmeabfuhr weiter zu verbessern.

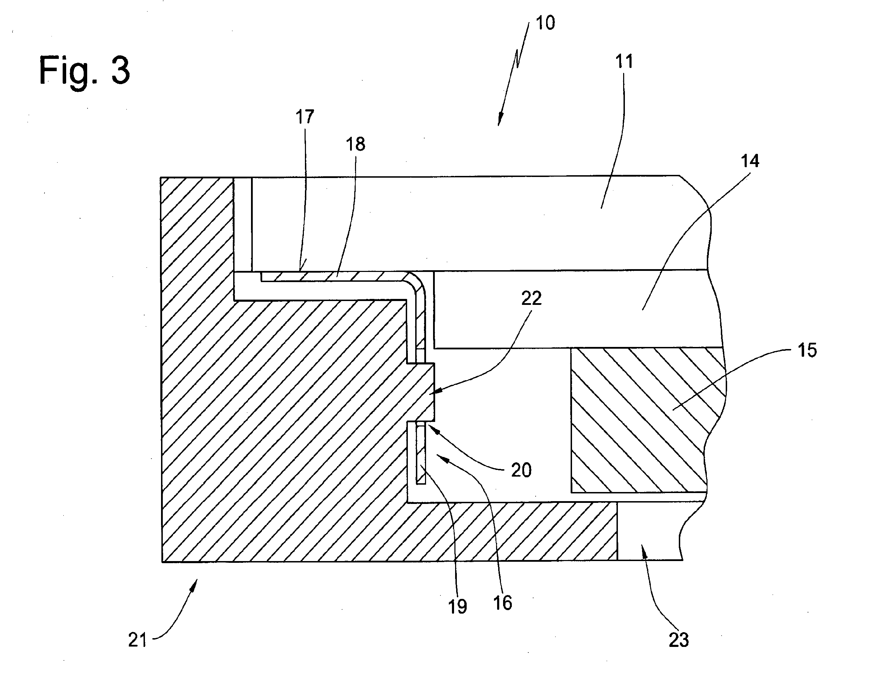

Fig. 3 zeigt den in Bezug auf Fig. 2 linksseitigen Teilabschnitt des Leuchtmittels 10. In dieser Darstellung ist noch einmal besonders gut die Verankerung des Anschlusskontaktes 16 im Isolierstoffgehäuse 21 zu entnehmen. Das Durchgreifen der Halteöffnung 20 des zweiten Kontaktschenkels 19 durch den Haltezapfen 22 führt zu einem Formschluss zwischen Isolierstoffgehäuse 21 und Anschlusskontakt 16. Zwischen dem ersten Kontaktschenkel 18 und der metallischen Schicht der Trägerplatte 11 wird ein Stoffschluss hergestellt. Dies geschieht in bevorzugter Weise mittels eines Ultraschall-Lötverfahrens. Andere stoffschlüssige Verbindungsarten wie das Schweißen oder Kleben sind jedoch denkbar.

Zur Halterung des aus Trägerplatte 11, Abdeckplatte 14 und den dazwischen gelagerten OLEDs gebildete und bei Bedarf um einen Kühlkörper 15 ergänzten Lichtelementes im Isolierstoffgehäuse zur Bildung des erfindungsgemäßen Leuchtmittels 10 ist der Stoffschluss seitens des ersten Kontaktschenkels 18 in Verbindung mit dem Formschluss seitens des zweiten Kontaktschenkels 19 vollkommen ausreichend. Insofern dient der Anschlusskontakt 16 neben der elektrischen Kontaktierung auch der mechanischen Halterung. Dies ist einer der wesentlichen Vorteile des erfindungsgemäßen Leuchtmittels.

In der Regel werden, wie eingangs beschrieben und auch hier dargestellt, mehrere Kontakte mit der metallischen Schicht elektrisch verbunden, um die Verteilung der Spannung und Stromstärke über die mit OLEDs versehene Oberfläche der Trägerplatte 11 gleichmäßig zu halten. Im Stand der Technik bedingt dies, dass Anschlusskontakte gleicher Polarität jeweils einzeln mit externen Anschlussleitungen versehen werden müssen. Bei der Erfindung hingegen ist es möglich, die elektrische Verbindung gleichartiger Pole untereinander innerhalb des Isolierstoffgehäuses 21 vorzunehmen, so dass die externe Verdrahtung lediglich noch über zwei Kontakte erfolgen muss. Hierzu können die Kontakte 16 mit geeigneten Verbindungselementen versehen sein. Denkbar sind hier Kontaktausbildungen als Schneid-Klemmkontakt oder Andruckkontakt oder als schraubenlose Kabelklemme.

Darüber hinaus ist es möglich, Elektrizität von den Anschlusskontakten 16 abzugreifen und zur Spannungsversorgung eines weiteren Leuchtmittels nach Art eines Durchschleifens zu nutzen. Dies ist in Kombination mit der innerhalb des Isolierstoffgehäuses erfolgten elektrischen Verbindung über gesonderte Verbindungselemente von besonderem Vorteil, da die Spannungsversorgung dann nicht über die metallische Schicht erfolgen muss.

In der in den Figuren dargestellten Form wird das Lichtelement durch das Isolierstoffgehäuse 21 mit einem Sockel versehen, welcher die Handhabbarkeit und Montage von mit OLEDs versehenen Leuchtmitteln 10 erheblich vereinfacht und die Möglichkeit zur Schaffung leistungsfähiger Sockel-Fassungssysteme ermöglicht.

Es ist jedoch durchaus denkbar, das lediglich im Bereich einiger Kontakte einzelne Isolierstoffgehäuse vorgesehen sind. Ebenso ist es möglich, dass das Lichtelement zwar mit Anschlusskontakten versehen ist, aber kein Isolierstoffgehäuse als unmittelbar zugehöriges Bauteil aufweist.. Es wären dann ein oder mehrere Isolierstoffgehäuse vorzusehen, beispielsweise als Leuchtenteile, in welche die Anschlusskontakte 16 einsetzbar sind. Die Verbindung zwischen Kontakt und Isolierstoffgehäuse kann dann beispielsweise auch durch einen Reibschluss erfolgen, wobei mittels Schneid-Klemmtechnik gleichzeitig beim Einsetzen der Kontakte in das Isolierstoffgehäuse die elektrische Kontaktierung mit Anschlussleitern erfolgen kann. Andere Formen einer das Leuchtmittel 10 haltenden Festlegung der Anschlusskontakte 16 im Isolierstoffgehäuse sind denkbar.

### Bezugszeichenliste:

- 10: Leuchtmittel
- 11: Trägerplatte
- 12: Sichtfläche
- 13: Licht emittierende Oberfläche
- 14: Abdeckplatte
- 15: Kühlkörper
- 16: elektrische Anschlusskontakte
- 17: Kontaktfläche
- 18: erster Kontaktschenkel
- 19: zweiter Kontaktschenkel
- 20: Halteöffnung
- 21: Isolierstoffgehäuse
- 22: Haltezapfen
- 23: Ausnehmung

## Patentansprüche

1. Leuchtmittel mit wenigstens einer organischen, Licht emittierenden Diode (OLED), die auf einem Trägermaterial aufgebracht sind, welches mit einer metallischen Schicht bedampft ist, die der Spannungsversorgung der OLED dient und hierfür mit Anschlussleitern in Verbindung steht, **dadurch gekennzeichnet, dass**
- die metallische Schicht mehrere Pole ausbildet und mehrere Anschlusskontakte eine stoffschlüssige Verbindung mit der metallischen Schicht eingehen, wobei die Kontakte gleicher Pole untereinander innerhalb des Isolierstoffgehäuses miteinander elektrisch verbunden sind,
- ein einteiliges Isolierstoffgehäuse (21) vorgesehen ist,
- die Anschlusskontakte (16) unmittelbar in dem Isolierstoffgehäuse festgelegt sind,
- die unmittelbare Festlegung der Anschlusskontakte (16) im Isolierstoffgehäuse (21) der Halterung des Leuchtmittels im Isolierstoffgehäuse dient.
- der im Isolierstoffgehäuse festgelegte Anschlusskontakt der unmittelbaren Anbindung der Anschlussleiter dient.

2. Leuchtmittel nach Anspruch 1, **dadurch gekennzeichnet, dass** wenigstens ein im Isolierstoffgehäuse festgelegter Anschlusskontakt zugänglich ist, um mittels einer elektrischen Verbindung ein weiteres Leuchtmittel mit Elektrizität zu Versorgen

3. Leuchtmittel nach einem der vorhergehenden Ansprüche, **dadurch gekennzeichnet, dass** das Isolierstoffgehäuse einen Kühlkörper trägt, der die beim Betrieb der OLED entstehende Wärme abführt.

4. Leuchtmittel nach einem der vorhergehenden Ansprüche, **dadurch gekennzeichnet, dass** der Stoffschluss zwischen dem Kontakt und der metallischen Schicht mittels Ultraschalllöten, Schweißen oder Kleben hergestellt wird.

5. Leuchtmittel nach einem der vorhergehenden Ansprüche, **dadurch gekennzeichnet, dass** das Leuchtmittel in das Isolierstoffgehäuse eingebettet ist und das Isolierstoffgehäuse so einen Sockel ausbildet, welcher in einem im Wesentlichen form- und anschlusskomplementären Fassungsteil lagerbar ist.

6. Leuchtmittel nach einem der vorhergehenden Ansprüche, **dadurch gekennzeichnet, dass** das Leuchtmittel ausschließlich vermittels der Verbindung zwischen Kontakt und Trägermaterial einerseits und Festlegung des Kontakt im Isolierstoffgehäuse andererseits am Isolierstoffgehäuse gehalten ist.

7. Leuchtmittel nach Anspruch 5 und/oder 6, **dadurch gekennzeichnet, dass** das Isolierstoffgehäuse die Sichtfläche des Leuchtmittels unbedeckt lässt und insbesondere mit der Oberflächenebene der Sichtfläche abschließt.

## Claims

1. Illuminant having at least one organic, light emitting diode (OLED) which are applied to a carrier material vapour-deposited with a metal layer which serves for supplying the OLED with voltage and for this is connected to connecting conductors, **characterised in that**
- the metal layer forms plural poles and plural connecting contacts form a material bond with the metal layer, the contacts of identical poles being electrically connected to one another within the insulating material housing,
- a one-piece insulating material housing (21) is provided,
- the connecting contacts (16) are directly fixed in the insulating material housing,
- the direct fixing of the connecting contacts (16) in the insulating housing (21) serves for supporting the illuminant in the insulating material housing,
- the connecting contact fixed in the insulating material housing serves for direct connection to the connecting conductors.

2. Illuminant according to Claim 1, **characterised in that** at least one connecting contact fixed in the insulating material housing is accessible to provide a further illuminant with electricity by means of an electrical connection.

3. Illuminant according to one of the preceding claims, **characterised in that** the insulating material housing carries a cooling body which dissipates the heat generated during operation of the OLED.

4. Illuminant according to one of the preceding claims, **characterised in that** the material bonding between the contact and the metal layer is provided by means of ultrasonic soldering, welding or adhesive bonding.

5. Illuminant according to one of the preceding claims, **characterised in that** the illuminant is embedded in the insulating material housing and the insulating material housing thus forms a base which is supportable in a substantially form- and connection-complementary socket portion.

6. Illuminant according to one of the preceding claims, **characterised in that** the illuminant is exclusively supported on the insulating material housing by means of the connection between contact and carrier material on the one hand and fixing of the contact in the insulating material housing on the other hand.

7. Illuminant according to Claim 5 and/or 6, **characterised in that** the insulating material housing leaves the viewing surface of the illuminant uncovered and in particular terminates with the surface plane of the viewing surface.

## Revendications

1. Moyen d'éclairage avec au moins une diode électroluminescente organique (OLED) qui est montée sur un matériau support lequel est revêtu d'une couche métallique qui sert à l'alimentation en tension de l'OLED et est reliée, à cet effet, à des conducteurs de connexion, **caractérisé en ce que** :
- la couche métallique forme plusieurs bornes et que plusieurs contacts de connexion sont reliés par liaison de matière à la couche métallique, les contacts des mêmes bornes étant reliés électriquement ensemble, entre eux, au sein du boîtier en matériau isolant,
- un boîtier en matériau isolant (21) monobloc est prévu,
- les contacts de connexion (16) sont fixés directement dans le boîtier en matériau isolant,
- la fixation directe des contacts de connexion (16) dans le boîtier en matériau isolant (21) sert à maintenir le moyen d'éclairage dans le boîtier en matériau isolant,
- le contact de connexion fixé dans le boîtier en matériau isolant sert à raccorder directement les conducteurs de connexion.

2. Moyen d'éclairage selon la revendication 1, **caractérisé en ce qu'**au moins un contact de connexion fixé dans le boîtier en matériau isolant est accessible pour alimenter en électricité un autre moyen d'éclairage à l'aide d'une liaison électrique.

3. Moyen d'éclairage selon l'une des précédentes revendications, **caractérisé en ce que** le boîtier en matériau isolant porte un corps de refroidissement qui évacue la chaleur dégagée lors du fonctionnement de l'OLED.

4. Moyen d'éclairage selon l'une des précédentes revendications, **caractérisé en ce que** la liaison de matière entre le contact et la couche métallique est réalisée par soudure à ultrasons, soudage ou collage.

5. Moyen d'éclairage selon l'une des précédentes revendications, **caractérisé en ce que** le moyen d'éclairage est encastré dans le boîtier en matériau isolant et **en ce que** le boîtier en matériau isolant forme ainsi un socle, lequel peut être placé dans une pièce de monture essentiellement de forme et de liaison complémentaires.

6. Moyen d'éclairage selon l'une des précédentes revendications, **caractérisé en ce que** le moyen d'éclairage est maintenu exclusivement par liaison entre contact et matériau support, d'une part, et par fixation du contact dans le boîtier en matériau isolant, d'autre part, au niveau du boîtier en matériau isolant.

7. Moyen d'éclairage selon la revendication 5 et/ou 6, **caractérisé en ce que** le boîtier en matériau isolant laisse découverte la face visible du moyen d'éclairage et notamment se termine avec le niveau de la face supérieure de la face visible.
